# EUROPÄISCHE PATENTSCHRIFT

(11) **EP 0 892 999 B1**
(45) Veröffentlichungstag und Bekanntmachung des Hinweises auf die Patenterteilung: **24.05.2006**
(21) Anmeldenummer: 97931697.3
(22) Anmeldetag: 02.07.1997
(51) Int. Cl.: H01R 13/658, H05K 5/00

(54) **ELEKTRISCHES SCHALT- UND STEUERGERÄT**
ELECTRICAL SWITCHING AND CONTROL DEVICE
DISPOSITIF DE COMMUTATION ET DE COMMANDE

(30) Priorität: 15.11.1996 DE 29619867 U
(43) Veröffentlichungstag der Anmeldung: 27.01.1999
(73) Patentinhaber: ROBERT BOSCH GMBH, 70442 Stuttgart (DE)
(72) Erfinder: BENTZ, Willy, D-74343 Sachsenheim (DE); SCHIEFER, Peter, D-74199 Untergruppenbach (DE); DEPTULA, Piotr, D-75428 Illingen (DE)
(86) Internationale Anmeldenummer: PCT/DE1997/001379
(87) Internationale Veröffentlichungsnummer: WO 1998/022993

(56) Entgegenhaltungen:
- WO-A-92/11745
- DE-A- 3 310 477
- DE-A- 3 345 701
- US-A- 4 473 755
- US-A- 5 228 871
- US-A- 5 285 010

## Beschreibung

### Stand der Technik

Die Erfindung bezieht sich auf ein elektrisches Schalt- und Steuergerät nach der Gattung des Anspruchs 1. Ein derartiges Schalt- und Steuergerät ist durch die DE 33 10 477 A1 bekannt.

Bei diesem bekannten Schalt- und Steuergerät sind Metallpins in einen Steckerkörper eingesetzt, um so mechanisch geschützt eine Messerleiste zu bilden. Diese Messerleiste bietet aber keinen Schutz gegen elektrische und elektromagnetische Einflüsse. Außerdem kann sie auch nicht die Umgebung vor Beeinflussungen schützen, die durch Abstrahlungen des Schalt- und Steuergerätes auftreten.

Ferner wird auf US 5,285,010 verwiesen, das ein Steuergerät gemäß dem Oberbegriff von Anspruch 1 offenbart.

Der Erfindung liegt die Aufgabe zugrunde, diesen Nachteil zu vermeiden und ein elektrisches Schalt- und Steuergerät zu schaffen, das gegen äußere elektrische oder elektromagnetische Einflüsse geschützt ist und das auch die Umgebung des Schalt- und Steuergerätes vor Strahlungen bewahrt, die im Schalt- und Steuergerät selbst ihren Ursprung haben. Außerdem soll auch eine zuverlässige und frei gestaltbare Verbindung zwischen der Leiterplatte als Schaltungsträger und dem Stecker bzw. einem, an dem Stecker über einen Gegenstecker angeschlossenen Kabelbaum erreicht werden.

Diese Aufgabe wird gemäß der Erfindung gelöst durch die kennzeichnenden Merkmale des Anspruchs 1. Vorteilhafte Weiterbildungen des Gegenstandes des Anspruches 1 ergeben sich aus den Merkmalen der Unteransprüche sowie aus der Beschreibung und der Zeichnung.

### Zeichnung

Ein Ausführungsbeispiel der Erfindung ist in der Zeichnung dargestellt und in der nachfolgenden Beschreibung näher erläutert. Es zeigen:

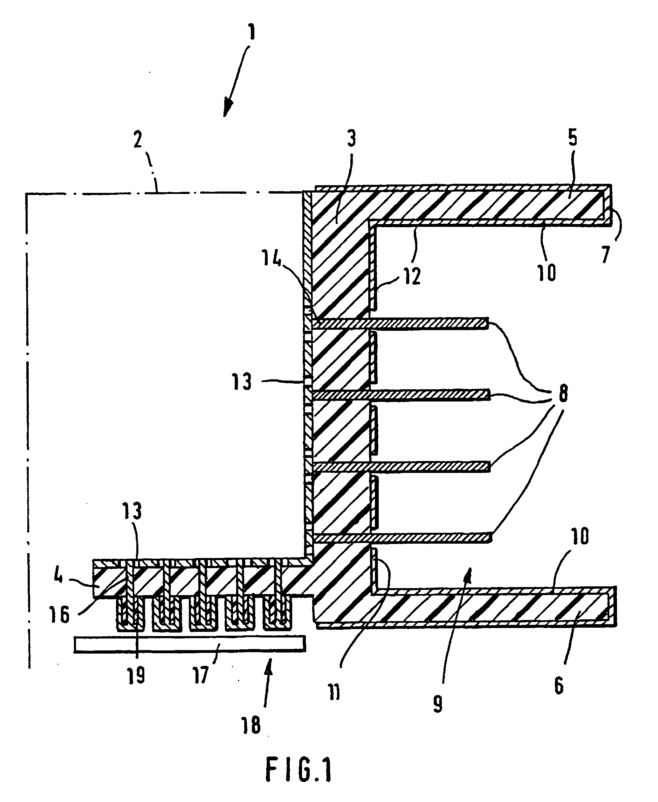

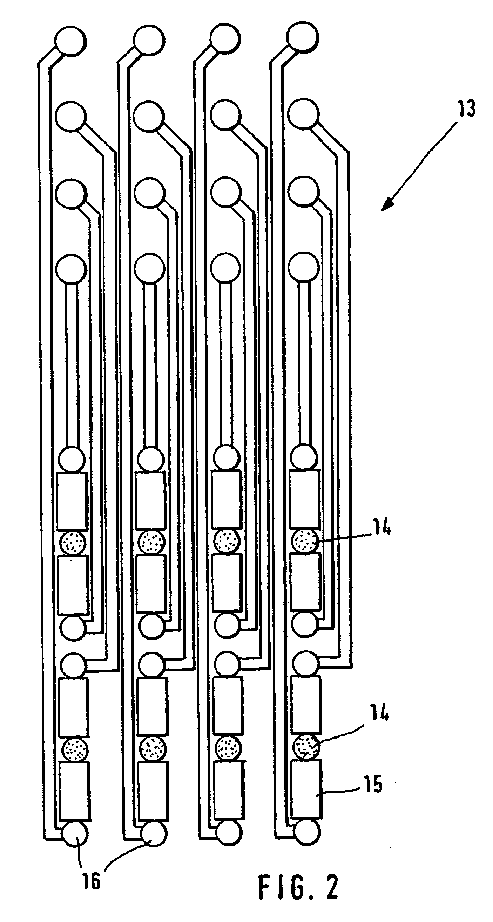

Figur 1 Teile des Schalt- und Steuergeräts in einer Schnittdarstellung und Figur 2 eine metallisch strukturierte Schicht des Steuergeräts in einer Draufsicht.

### Beschreibung des Ausführungsbeispiels

Ein nicht in allen Einzelheiten dargestelltes Schalt- und Steuergerät 1 hat ein aus Kunststoff bestehendes Gehäuse 2 mit mehreren Gehäuseabdeckungen, von denen in der Figur 1 zwei dargestellt sind, und zwar eine seitliche Gehäuseabdeckung 3 und eine untere Gehäuseabdeckung 4.

Die seitliche Gehäuseabdeckung 3 übergreift mit mindestens zwei Wangen 5 und 6 den Hohlraum eines Steckers 7, der mit einer Vielzahl von Pins 8 ausgerüstet ist, die eine sogenannte Messerleiste 9 bilden. Der Stecker 7 ist mit seiner Messerleiste 9 zur Kopplung mit einem nicht mehr dargestellten Kabelbaumstecker bestimmt. Die Innenflächen des Steckers 7, d.h. die Innenflächen 10 der Wangen 5 und 6 und eine Bodenfläche 11 des Steckers 7 sind mit einer metallischen Beschichtung 12 versehen, die dazu bestimmt ist, die elektromagnetische Strahlung (Ein- und Abstrahlung) abzuschirmen. Die Messerleiste 9 ist in einem Reflow-Lötprozeß verarbeitbar.

Die Pins 8 durchdringen die Gehäuseabdeckung 3 und sind auf der Innenseite - also innen im Gehäuse 2 - in einer metallischen strukturierten Schicht 13 eingebettet. Diese Innenseite des Gehäuses 2 wird auch Layout-Seite genannt und ist in der Figur 2 dargestellt. Die Schicht 13 ist in MID-Technik (Molded Interconnected Devices) hergestellt.

Bei dieser Technik werden hitzebeständige Kunststoffe verwendet, die einerseits gut im Kunststoffspritzverfahren verarbeitbar sind und die andererseits eine stabile Haftung der Leitmaterialien gewährleisten. Die in dieser Technik erstellten Teile können in einer Standard-Elektronikfertigung verarbeitet werden, so daß das Löten sowohl in einem Reflow-Ofen als auch auf einer Lötwelle möglich ist.

Die in der Figur 2 dargestellten gepunkteten Kreise sind Durchkontaktierungen 14 zur Masse, die weißen Rechtecke stellen elektrische oder elektronische Bauteile dar, wie z.B. Kondensatoren 15, und die weißen Kreise sind Durchkontaktierungen 16 zu einer Leiterplatte 17 auf einer Schaltungsträgerseite 18, die in der Figur 1 dargestellt ist. Die Durchkontaktierungen 14 und 16 dienen zur Weiterleitung von Signalen. Statt einer Leiterplatte 17 kann auch eine Folie oder ein Substrat verwendet werden.

Zur Befestigung der Leiterplatte 17 am Gehäuse 2 und zu ihrer Kontaktierung sind beschichtete Kunststoff-Pfosten 19 vorgesehen, die Lötstellen bilden. Diese Pfosten 19 können auf verschiedene Weise, wie z. B. Kleben, Bonden oder Reflowlöten mit der Leiterplatte 17 verbunden werden. Beim Ausführungsbeispiel wird nach dem BGA-Technik (Ball Grid Array) im Reflow-Lötverfahren gelötet.

Die BGA-Technik wird insbesondere bei Bauelementen angewandt, die eine große Anzahl von Anschlüssen aufweisen. Die Anschlüsse enthalten jeweils einen senkrecht vom Körper des Bauelements abstehenden Pin 8, an dessen freiem Ende Lot in Form einer Kugel angebracht ist. Die Pins 8 werden auf Anschlußfelder der Leiterplatte 17 gelegt, das Lot aufgeschmolzen und so eine elektrische Verbindung zwischen den Pins 8 und den zugeordneten Anschlußfeldern hergestellt.

### Wirkungsweise

Die innen im Gehäuse 2 angebrachte Schicht 13 dient dazu, das Schalt- und Steuergerät 1 vor äußeren Einflüssen elektrischer und/oder elektromagnetischer Art zu schützen. Außerdem bietet das Gehäuse 2 einen mechanischen Schutz.

Der im Bereich der Messerleiste 9 mit einer Beschichtung 12 versehene Stecker 7 hat die Eigenheit, daß er die Umgebung des Schalt- und Steuergerätes vor elektromagnetischen Strahlungen abschirmt.

Aufgrund der Durchkontaktierungen 14 und 16 sind die notwendigen elektrischen Querverbindungen, z.B. zwischen einem Pin 8 und einem beliebigen Punkt auf der Leiterplatte 17, auch als Stromdurchschleifungen bezeichnet, einfach zu realisieren. Schließlich können bei Bedarf noch weitere elektronische Bauelemente, wie beispielsweise Kondensatoren, in einfache Weise auf der Messerleiste montiert werden.

## Patentansprüche

1. Elektrisches Schalt- und Steuergerät (1) für Kraftfahrzeuge mit einem Gehäuse (2), das an einer Seite einem Stecker (7) als Aufnahme für einen Gegenstecker zur Bildung einer elektrischen Steckverbindung aufweist, der Stecker (7) mehrere, voneinander isolierte, metallische Pins (8) enthält, die eine Messerleiste (9) bilden, mit der beim Schließen der Steckverbindung Gegenkontaktelemente des Gegensteckers elektrisch leitend verbunden werden, mit einer am Gehäuse (2) angeordneten Leiterplatte (17), die mit elektrischen Bauelementen und Leiterbahnen ausgerüstet ist, die mit dem Stecker (7) kontaktiert sind wobei an einer der Messerleiste (9) abgekehrten Seite einer Gehäuseabdeckung (3) eine metallische, strukturierte Schicht (13) vorgesehen ist, die über Durchkontaktierungen (14) mit den Pins (8) der Messerleiste (9) verbunden ist, **dadurch gekennzeichnet, daß** der Stecker (7) auf der zur Aufnahme des Gegensteckers vorgesehenen Seite an Innenflächen (10) und einer Bodenfläche (11) mit einer Beschichtung (12) versehen ist, die elektromagnetische Strahlungen abschirmt und die metallische strukturierte Schicht (13) andererseits über Durchkontaktierungen (16) mit der Leiterplatte (17) verbunden ist, welche Schicht (13) das Schalt- und Steuergerät (1) vor äußeren Einflüssen elektrischer oder elektromagnetischer Art schützt.

2. Elektrisches Schalt- und Steuergerät nach Anspruch 1, **dadurch gekennzeichnet, daß** auf der metallischen, strukturierten Schicht (13) elektronische Bauelemente, wie Kondensatoren (15) plazierbar sind.

3. Elektrisches Schalt- und Steuergerät nach Anspruch 1 oder 2, **dadurch gekennzeichnet, daß** an einer der Leiterplatte (17) zugekehrten Wandfläche des Gehäuses (2) Kunststoff-Pfosten (19) vorgesehen sind, an denen die zur Leiterplatte (17) führenden Durchkontaktierungen (16) festgelegt sind.

## Claims

1. Electrical switching and control device (1) for motor vehicles having a housing (2) which has a plug (7) on one side as a receptacle for an opposing plug for the purpose of forming an electrical plug connection, the plug (7) containing two or more metallic pins (8) which are insulated from one another and form a male multipart connector (9), by means of which opposing contact elements of the opposing plug are electrically conductively connected when the plug connection is closed, having a printed circuit board (17) which is arranged on the housing (2) and is fitted with electrical components and conductor tracks with which contact is made by the plug (7), a metallic, patterned layer (13) being provided on one side of a housing cover (3), which side faces away from the male multipart connector (9), said layer (13) being connected to the pins (8) of the male multipart connector (9) via through-platings (14), **characterized in that** the plug (7) is provided with a coating (12) on the side provided for accommodating the opposing plug, on inner faces (10) and a base face (11), said coating (12) screening electromagnetic interference, and the metallic, patterned layer (13) is connected on the other side to the printed circuit board (17) via through-platings (16), which layer (13) protects the switching and control device (1) against external influences of an electrical and electromagnetic nature.

2. Electrical switching and control device according to Claim 1, **characterized in that** electronic components, such as capacitors (15), can be placed on the metallic, patterned layer (13).

3. Electrical switching and control device according to Claim 1 or 2, **characterized in that** plastic posts (19) are provided on a wall face of the housing (2) which faces the printed circuit board (17), the through-platings (16) leading to the printed circuit board (17) being fixed to said plastic posts (19).

## Revendications

1. Appareil de commutation et de commande électrique (1) pour véhicules automobiles, comprenant un boîtier (2) qui présente sur un côté un connecteur (7) destiné à recevoir une contre-fiche pour une connexion électrique, le connecteur (7) contenant plusieurs broches (8) métalliques isolées les unes des autres, et qui forment une réglette de contact à couteaux (9) qui lors de la fermeture de la connexion, est reliée électriquement à des éléments de contact correspondants de la contre-fiche avec pour le boîtier (2) une plaquette de circuit imprimé (17) équipée de composants électriques et de pistes conductrices en contact avec le connecteur (7), étant prévue et avec du côté opposé de la réglette à couteaux (9) d'un couvercle de boîtier (3), une couche (13) structurée métallique reliée par des connexions transversales (14) avec les broches (8) de la réglette à couteaux (9),
**caractérisé en ce que**
sur le côté recevant la contre-fiche le connecteur (7) comporte sur ses surfaces intérieures (10) et surface de fond (11) un revêtement (12) qui isole des rayonnements électromagnétiques, et la couche (13) structurée métallique est reliée de l'autre côté par les connexions transversales (16) à la plaque conductrice (17), la couche (13) protégeant l'appareil de commutation et de commande (1) des influences extérieures de type électrique ou électromagnétique.

2. Appareil de commutation et de commande électrique selon la revendication 1,
**caractérisé en ce que**
des composants électroniques, tels que des condensateurs (15), peuvent être placés sur la couche (13) structurée métallique.

3. Appareil de commutation et de commande électrique selon la revendication 1 ou 2,
**caractérisé en ce qu'**
une surface de paroi du boîtier (2) tournée vers la plaquette de circuit imprimé (17) comporte des plots de matière plastique (19) sur lesquels sont fixées les connexions transversales (16) menant à la plaquette de circuit imprimé (17).
